(19) **Europäisches Patentamt / European Patent Office / Office européen des brevets**

(11) **EP 4 768 293 A1**

(12) **EUROPEAN PATENT APPLICATION**

(43) Date of publication:
01.07.2026 Bulletin 2026/27

(21) Application number: 25207996.7

(22) Date of filing: 10.10.2025

(51) International Patent Classification (IPC):
| | |
|---|---|
| *B60K 11/02* (2006.01) | *B60L 58/27* (2019.01) |
| *B60L 15/02* (2006.01) | *B60L 53/24* (2019.01) |
| *B60L 15/08* (2006.01) | *H02J 7/90* (2026.01) |
| *B60L 53/62* (2019.01) | *B60L 15/20* (2006.01) |
| *B60L 50/51* (2019.01) | *B60L 50/60* (2019.01) |
| *B60L 53/10* (2019.01) | *B60L 53/14* (2019.01) |
| *B60L 58/26* (2019.01) | *H01M 10/613* (2014.01) |
| *H01M 10/615* (2014.01) | *H01M 10/625* (2014.01) |
| *H02K 11/00* (2016.01) | *H02M 1/12* (2006.01) |
| *H03K 3/017* (2006.01) | *H03K 7/08* (2006.01) |

(52) Cooperative Patent Classification (CPC):
**B60L 58/27; B60K 11/02; B60L 3/0061; B60L 15/007; B60L 15/025; B60L 15/08; B60L 15/20; B60L 50/51; B60L 50/60; B60L 53/11; B60L 53/14; B60L 53/24; B60L 53/62; B60L 58/26; H01M 10/61;** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 11.10.2024 US 202418913664

(71) Applicant: **Atieva, Inc.**
**Newark, CA 94560 (US)**

(72) Inventors:
• **Shah, Harsh Sanjay**
**Fremont, 94555 (US)**
• **Yang, Le**
**San Jose, 95134 (US)**
• **Surada, Rambabu**
**Fremont, 94536 (US)**
• **Biskup, Dick**
**Sunnyvale, 94087 (US)**
• **Yang, Zefan**
**San Jose, 94560 (US)**

(74) Representative: **Daub, Thomas**
**Daub PartG mbB**
**Bahnhofstraße 5**
**88662 Überlingen (DE)**

Remarks:
Claims 16, 18 and 19 are deemed to be abandoned due to non-payment of the claims fees (Rule 45(3) EPC).

(54) **ENHANCED STATIC HEATING OF EV BATTERY PACK USING DRIVE UNITS**

(57) An electric vehicle (EV) includes a battery pack, an electric motor, a drive circuit configured to drive the electric motor, a heat transfer material, arranged to transfer thermal energy from the electric motor to the battery pack, and a controller. The controller is configured to determine that the EV is connected to an external charger. In response, the controller generates the control signals comprising a waveform pattern that is free of zero volt vectors. The controller transmits the control signals to the drive circuit to drive the electric motor in accordance with the waveform pattern while the external charger charges the battery pack.

FIG. 1

**EP 4 768 293 A1**

**(Cont. next page)**

(52) Cooperative Patent Classification (CPC): (Cont.)
**H02J 7/927; H02K 11/0094; H02M 7/53876;**
**H02P 27/08; H02P 29/62; H03K 3/017; H03K 7/08;**
B60L 2210/40; B60L 2220/42; B60L 2240/425;
B60L 2240/545; B60L 2260/20; H01M 10/443;
H01M 10/633; H01M 10/66; H02J 2207/20;
H02M 1/123; Y02T 10/70

**Description**

FIELD

Embodiments disclosed relate generally to automobile technology, and more particularly, to leveraging existing propulsion based electronics to heat a battery pack with reduced common mode noise and reduced charging time when the EV is charging.

BACKGROUND

Electric Vehicles (EVs) utilize electric motors rather than internal combustion engines for propulsion. EVs run on energy that is stored in a battery pack. The battery pack may be recharged through plugging into an EVSE (electric vehicle supply equipment). A variety of EVSE exist with agreed upon pre-defined requirements. EVSE include electrical conductors, software, communication protocols, and other related equipment. EVSE is commonly referred to as a charging station, charging dock, charge point, or EV charger, and may implement a specified interface, signaling, handshaking, (e.g., level 1 charging, level 2 charging, DC Fast Charging (level 3), etc.).

An EV battery pack stores energy to power the electric motor and EV electronics. A battery pack may be made up one or more battery modules, each containing connected battery cells. Depending on battery size, driving range and charging capabilities can vary from one EV to another. Most EVs can travel over 100 miles per charge, with some exceeding that comfortably. Charging times vary depending on battery capabilities and EVSE capabilities.

Long charging times is a barrier for widespread adoption of electric vehicles. Even with fast charging, charging a battery pack from 10% to 80% state of charge (SOC) or state of energy (SOE) can take more than 15 minutes compared to a traditional combustion vehicle that can fill up a tank in under a minute. As such, it is desirable to reduce the charging time of batteries generally, and specifically, for a battery pack of an EV.

SUMMARY

The following presents a simplified summary of one or more aspects in order to provide a basic understanding of such aspects. This summary is not an extensive overview of all contemplated aspects. This summary neither identifies key or critical elements of all aspects nor delineates the scope of any or all aspects. Its sole purpose is to present some concepts of one or more aspects in a simplified form as a prelude to the more detailed description that is presented later.

In an aspect of the present disclosure, an electric vehicle (EV) comprises a battery pack; an electric motor; a drive circuit comprising a plurality of power semi-conductors coupled to a direct current (DC) bus of the EV and coupled to the electric motor, the plurality of power semi-conductors configured to drive the electric motor; a heat transfer material, arranged to transfer thermal energy from the electric motor to the battery pack; and a controller. The controller is configured to perform operations comprising: in response to determining that the EV is connected to an external charger, generating the control signals to comprise a waveform pattern that is free of zero volt vectors; and transmitting the control signals to the drive circuit to drive the electric motor in accordance with the waveform pattern while the external charger charges the battery pack. The waveform pattern is tailored to drive the motor with reduced efficiency (relative to when driving the motor to spin during operation) and to reduce electromagnetic noise (e.g., common mode noise) throughout the EV, which could otherwise disturb the charging process. Such a waveform pattern is different from when the EV is operating in driving mode, where the controller generates the control signals with a more traditional waveform pattern comprising an eight vector pattern that includes two zero volt vectors.

In an embodiment, the waveform pattern comprises a total of three non-zero vectors implemented as pulse width modulated (PWM) signals. In an embodiment, the PWM signals are aligned without overlap of a high position. Additionally, the PWM signals may be aligned without overlap of a low position.

In an embodiment, the controller may generate second control signals to comprise a second waveform pattern and transmitting the second control signals to a second drive circuit to drive a second electric motor of the EV, in accordance with the second waveform pattern. In an embodiment, the second waveform pattern is different from the waveform pattern and does comprise a zero volt vector, and a first distance between the second electric motor to a battery charge circuit of the EV is greater than a second distance between the electric motor to the battery charge circuit of the EV. In an alternative embodiment, the second waveform pattern has a same pattern as the waveform pattern and is free of the zero volt vectors.

In an embodiment, the plurality of power semi-conductors comprises three pairs of transistors, each pair being electrically coupled to a winding of the electric motor and configured to couple the respective winding to either a positive terminal of the DC bus or a return terminal of the DC bus, in accordance with the waveform pattern of the control signals.

In an embodiment, the external charger comprises a DC fast charger. In an embodiment, determining that the EV is connected to the external charger comprises detecting one or more signals or states of those one or more signals, on a charge port of the EV.

In an embodiment, the heat transfer material comprises a liquid that is thermally coupled to the electric motor and thermally coupled to the battery pack.

In an embodiment, the EV comprises a common ground plane that is coupled to a low voltage power supply that powers signaling that communicates with the external charger, and is coupled to the electric motor.

In an embodiment, the waveform pattern comprises an increased switching frequency of 16kHz or greater relative to a second waveform pattern generated when the EV is driving.

Other technical features may be readily apparent to one skilled in the art from the following figures, descriptions, and claims.

BRIEF DESCRIPTION OF THE DRAWINGS

The present disclosure will be understood more fully from the detailed description given below and from the accompanying drawings of various embodiments, which, however, should not be taken to limit the embodiments described and illustrated herein, but are for explanation and understanding.

FIG. 1 shows an illustration of an electric vehicle and static heating during a charge process, in accordance with an embodiment.
FIG. 2 shows an example of a drive unit, in accordance with an embodiment.
FIG. 3 shows an example of vector-based control of a drive unit, in accordance with an embodiment.
FIG. 4 illustrates an example of common mode voltage that may be induced into a common ground of an EV when switching the motor with SVPWM, in accordance with an embodiment.
FIG. 5 illustrates an example of common mode voltage that may be induced into a common ground of an EV when switching the motor with non-zero vector control (NZVC), in accordance with an embodiment.
FIG. 6 shows a flow diagram of a method for performing static heating, in accordance with an embodiment.
FIG. 7 illustrates a comparison of battery charge times under different conditions, in accordance with an embodiment.
FIG. 8 is a high-level view of some embodiments of a vehicle, in accordance with an embodiment.

DETAILED DESCRIPTION

In the following description, numerous details are set forth. It will be apparent, however, to one of ordinary skill in the art having the benefit of this disclosure, that the embodiments described herein may be practiced without these specific details. In some instances, well-known structures and devices are shown in block diagram form, rather than in detail, in order to avoid obscuring the embodiments described herein.

Embodiments disclosed relate generally to automobile technology, and more particularly, to leveraging existing propulsion based electronics to heat a battery pack with reduced noise and increased efficiency.

Utilizing EV drive units (e.g., an electric motor and inverter) to generate heat for battery pre-conditioning effectively optimizes the battery pack's temperature for charging the vehicle batteries, such as in the case of DC fast charging (DCFC). Pre-conditioning the battery pack by adjusting its temperature to a desired range can be referred to as static heating. It may be desirable to detect when battery charging (e.g., DC fast charging) is initialized, and in response, command the EV drive unit to generate heat through a different commutation pattern than under normal (driving) operation. Additionally, it may be desirable to command the drive unit in a manner that reduces EMI noise resulting from the drive unit, which may otherwise compromise the control pilot and proximity pilot signals which may be part of the charge protocol (e.g., interrupting and/or delaying the charging process). Additionally, it may be desirable to command the drive unit in a manner that increases heat loss to expedite heat transfer into the battery pack from the EV drive unit.

Embodiments of the present disclosure may detect when a battery charge process is initialized (e.g., a DC fast charging process), and transmit a series of control commands (e.g., pulse width modulation (PWM) signals) to the inverter with a modified waveform pattern. This modified waveform pattern is different from the general driving waveform, specifically tailored for charging rather than to cause the motor to move efficiently. Driving the motor with this waveform may increase the loss across the electric motor (e.g., across the stator) which results in increased heat generation. The modified waveform pattern may address potential EMI which would otherwise result from static heating and disrupt the charging process. Embodiments of the present disclosure may drive the inverter with non-zero vector controlled pulse width modulation (NZVPWM) control signals, which may reduce the majority (e.g., over 90%) of common mode noise in the system that would otherwise result from operating the drive unit to perform static heating.

Some portions of the detailed description that follow are presented in terms of algorithms and symbolic representations of operations on data bits within a computer memory. These algorithmic descriptions and representations are the means used by those skilled in the data processing arts to most effectively convey the substance of their work to others skilled in the art. An algorithm is here, and generally, conceived to be a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. Unless specifically stated otherwise as apparent from the following discussion, it is appreciated that throughout the description, discussions utilizing terms such as "receiving", "transmitting", "storing", "determining", "accessing", "referencing", or the like, refer to the actions and processes of a computer system, or similar electronic computing device, that manipulates and transforms data represented as physical (e.g., electronic) quantities within the computer system's registers and memories into other data similarly represented as physical quantities within the computer system memories or registers or other such information storage, transmission or display devices.

The embodiments discussed herein may also relate to an apparatus for performing the operations herein. This apparatus may be specially constructed for the required purposes, or it may comprise a general-purpose computer selectively activated or reconfigured by a computer program stored in the computer. Such a computer program may be stored in a computer readable storage medium, such as, but not limited to, any type of disk including floppy disks, optical disks, CD-ROMs, and magnetic-optical disks, read-only memories (ROMs), random access memories (RAMs), EPROMs, EEPROMs, magnetic or optical cards, or any type of media suitable for storing electronic instructions.

The algorithms and displays presented herein are not inherently related to any particular computer or other apparatus. Various general-purpose systems may be used with programs in accordance with the teachings herein, or it may prove convenient to construct a more specialized apparatus to perform the required method steps. The required structure for a variety of these systems will appear from the description below. In addition, the embodiments discussed herein are not described with reference to any particular programming language. It will be appreciated that a variety of programming languages may be used to implement the teachings as described herein.

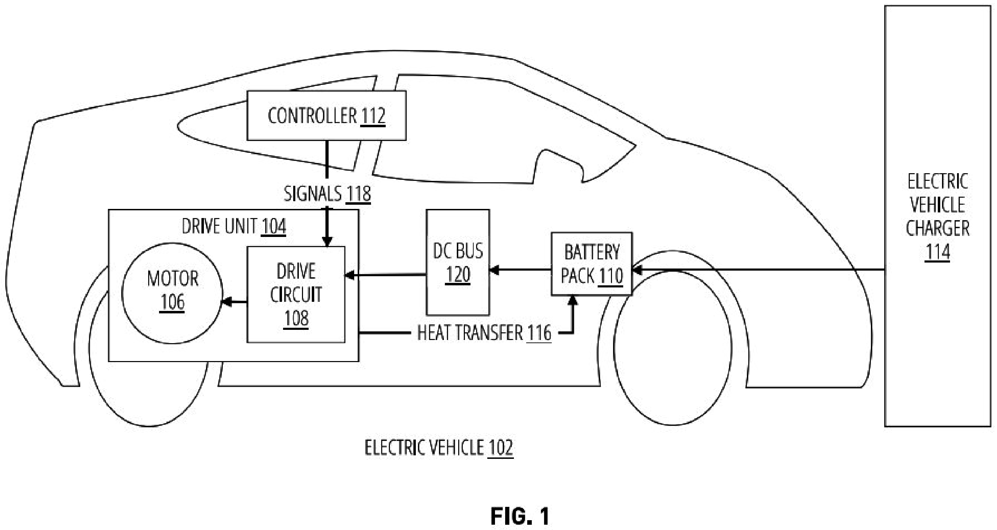

FIG. 1 shows an illustration of an EV 102 and static heating during a charge process, in accordance with an embodiment. Some details are omitted to emphasize features related to the present disclosure.

Long charging times is a major barrier for widespread adoption of electric vehicles. Heating the battery pack to optimum temperature significantly reduces charging time. An EV may utilize drive units to heat the battery pack to an optimum temperature through battery preconditioning. Increased motor and inverter losses may be realized through implementing an inverter modulation scheme that increases Total Harmonic Distortion (THD) and increasing switching frequency, which results in an increase in losses in the motor and inverter (also referred to as a drive circuit).

When a front drive unit (FDU) 104 is used to perform static heating during DC fast charging (DCFC) session, common mode noise may adversely impact low voltage (12v) signals on the charge gun (e.g., control and proximity signals) of an electric vehicle charger 114, given the FDU's closer proximity to charging infrastructure of EV 102, (e.g., a Multi-Purpose Box (MPB)).

Aspects described implement a modulation scheme which mitigates the common mode noise from the drive unit 104 when the drive circuit 108 is switching. This may improve the EV's ability to perform static heating of the battery, using one or more drive units 104 to place the battery temperature in an optimal range, thereby reducing charging time.

EV 102 comprises a battery pack 110 that includes a plurality of battery cells (e.g., cylindrical, prismatic, etc.). These cells may be interconnected electrically in series and parallel to form a desired DC voltage, current capacity, and power output. The battery pack 110 may comprise a battery management system (BMS) and sensors that may sense voltage, current, and temperature at one or more points of the battery pack 110. The battery pack may comprise an optimal charging temperature range, which may depend on the battery chemistry, how the batteries are packaged, etc. The optimal temperature range may be stored in computer readable memory as a setting in the BMS and/or other computing devices of the EV such as in controller 112. The optimal temperature may range from 10C to 50C, or from 20C to 40C, or another range. When the battery is extremely cold (-10C or lower), relying solely on a heat pump to prepare the battery for charging can be time consuming.

Battery pack 110 may be connected to a DC/DC converter (not shown) to generate a regulated and steady DC voltage (e.g., a voltage greater than 600Vdc). The output of the DC/DC converter may form the DC bus 120, which may include bus hardware (e.g., a low resistance electrically conductive structure, one or more terminals, etc.) The DC bus 120 may comprise a positive terminal and a negative terminal which may also be referred to as a DC return.

The EV comprises an electric motor 106. Electric motor 106 may be an alternating current (AC) electric motor. Electric motor 106 may comprise an induction motor (e.g., a three-phase induction motor), or other motor type (e.g., a permanent magnet synchronous motor (PMSM), etc.). Electric motor 106 converts battery energy into torque that turns the wheels of EV 102. The motor may be powered by alternating current (AC) generated by drive circuit 108. Drive circuit 108 may convert DC voltage from DC bus 120 to AC and apply the AC current through the stator of electric motor 106, which creates a magnetic field that applies a force on a magnet (e.g., on a rotor of the motor 106), resulting in a torque and rotation of the rotor of motor 106.

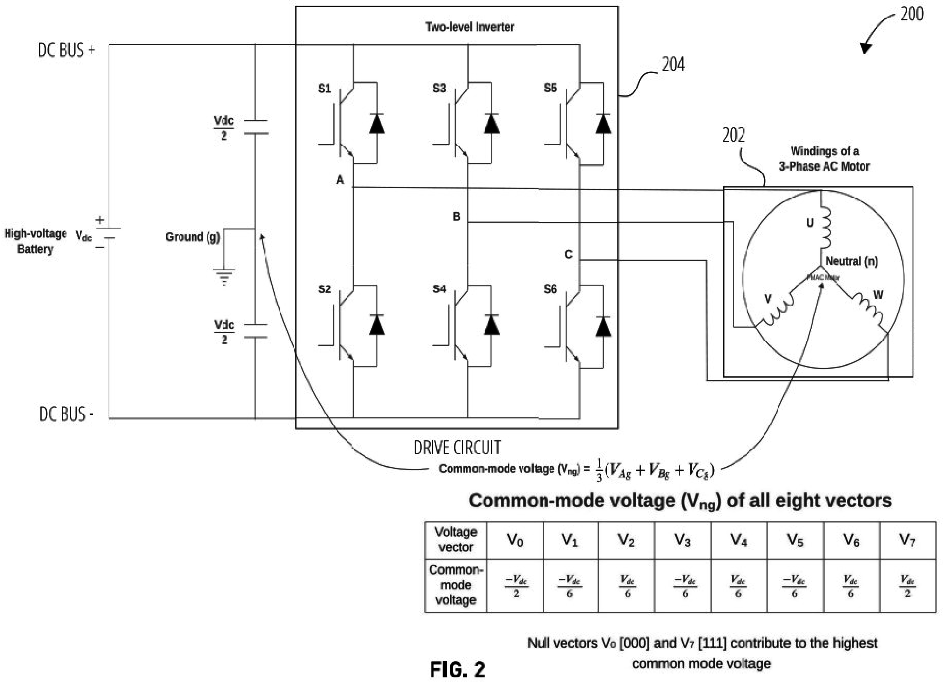

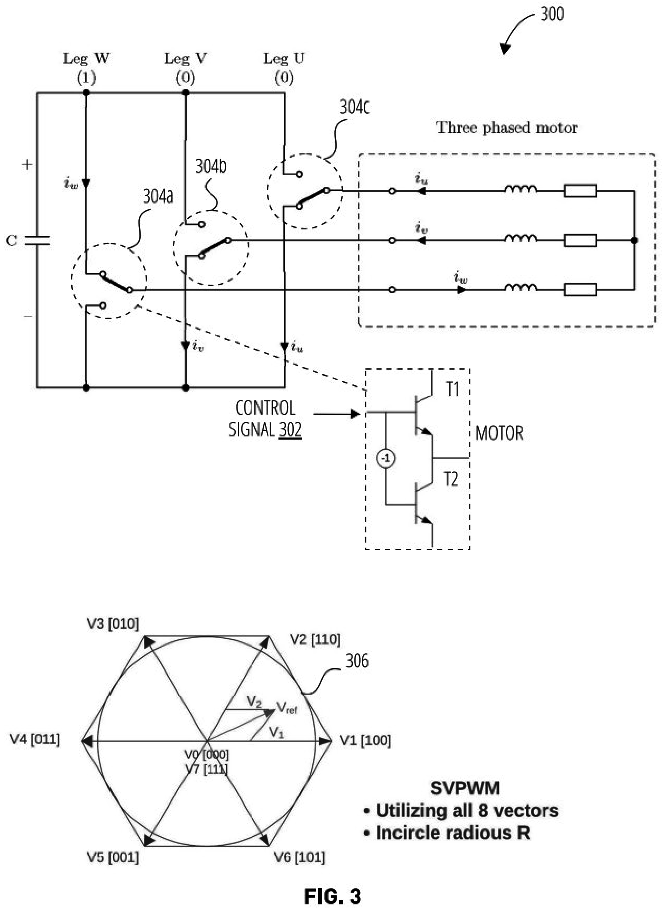

Drive circuit 108 comprises a plurality of power semi-conductors coupled to the DC bus 120 of the EV 102, and coupled to the electric motor 106. The plurality of power semi-conductors are configured to drive the electric motor 106 in accordance with control signals 118. Drive circuit 108 may be referred to as an inverter. Depending on application, different power switching semi-conductors may be used, such as power transistors, IGBTs, MOSFETs, etc. These are connected to form a circuit that drives current through windings of the motor 106 when the semi-conductors are driven to close (conduct) or open in accordance with the control signals 118. Examples of a drive circuit topology for driving a three-phase motor are shown in FIG. 2 and FIG. 3.

Drive circuit 108 and motor 106 may collectively be referred to as drive unit 104. In an embodiment, EV 102 may comprise one or more, or two or more drive units (e.g., a front drive unit and a rear drive unit), each with a respective drive circuit 108 and motor 106.

The EV 102 comprises a heat transfer material 116, arranged to transfer thermal energy from the electric motor 106 and/or the drive circuit 108 to the battery pack 110. In an embodiment, the heat transfer material 116 may comprise fluid (e.g., a liquid coolant, air, etc.). In another embodiment, the heat transfer material 116 may comprise a solid material such as conducting heat through a chassis, heat pipe, or heat plate with low thermal resistance (e.g., a metal). In an embodiment, the heat transfer material 116 may be actively pumped or fanned from the motor 106 to the battery pack 110, or it may passively transfer thermal energy (e.g., without pumping, a fan, etc.) solely though thermal conduction.

The EV 102 may implement static heating. Static heating refers to using drive circuit 108 and the motor 106 (and windings thereof) to generate heat and warm up the battery pack 110 when the EV 102 is stationary and being charged by electric vehicle charger 114.

Controller 112 may be configured to determine when the EV 102 is connected to an external electric vehicle charger 114. In response to determining that the EV 102 is connected to an external charger 114, the controller may generate control signals 118 to command drive circuit 108 according to the control signals 118. The EV 102 may comprise a common ground plane (not shown) such as a chassis and/or other dedicated electrically conductive structure that is electrically or electromagnetically coupled to a low voltage power supply that powers signaling that communicates with the external charger, and is also coupled to the electric motor 106. This coupling introduces potential noise issues caused by running the electric motor 106 while charging, because the noise may disrupt signal communication (e.g., a pilot signal, handshake, electronic heartbeat, etc.) between the electric vehicle charger 114 and the EV 102 during or at the start of charging, which may ultimately disrupt or delay charging (e.g., causing unwanted pauses, restarts, or complete stoppage).

Controller 112 may, in response to being connected to the external charger, generate the control signals 118 to comprise a waveform pattern that is free of zero volt vectors. In an embodiment, the control signals 118 may comprise exactly three pulse width modulated signals. A zero volt vector may be defined as when all of the signals are either high at the same time, or low at the same time. As such, the controller 112 may generate a waveform pattern where each signal is, at any given time, either high or low, but at no time is this waveform pattern driving all three signals high at the same time, or low at the same time. Each signal drives a corresponding pair of power semiconductors (one of the pair is driven with the signal, and the other of the pair with the inverse of the signal). The states of these three signals may repeat periodically, and this periodic repeating pattern of states (that is free of zero volt vectors) may be referred to as a static heating waveform pattern. Controller 112 transmits the control signals 118 to the drive circuit 108 to drive the electric motor 106 in accordance with the waveform pattern while the external charger 114 charges the battery pack 110.

In an embodiment, the waveform pattern comprises a total of three non-zero vectors implemented as pulse width modulated (PWM) signals. In an embodiment, the PWM signals are aligned without overlap of a high position (and/or without overlap of a low position). Details of the waveform pattern are described in further detail in other sections. The waveform pattern for static heating is specific to when the EV is charging. Further, it may be performed when charging and in response to the temperature of the battery pack 110 being below a threshold (e.g., below the optimal temperature range of the battery).

For example, if the temperature of the battery pack 110 is 5C and the optimal temperature range is 20C-40C, controller 112 may transmit the control signals with the static heating waveform pattern until the threshold temperature (e.g., 20C) is reached. If the battery pack 110 is already within the range when charging is being performed or initiated, controller 112 may refrain from performing the static reheating (e.g., the generation and transmitting of the waveform pattern).

When the controller 112 operates under a different mode (e.g., to drive the EV), the controller 112 generates the control signals with a second waveform pattern that is different from the static heating waveform pattern. This second waveform pattern may comprise a more traditional eight vector pattern that includes two zero volt vectors. In an embodiment, the static heating (non-zero vector) waveform pattern comprises an increased switching frequency of 16kHz or greater relative to the second waveform pattern generated when the EV is driving. This increased switching frequency may reduce the audible noise generated by the drive circuit 108 and motor 106.

As discussed, EV 102 may comprise a second drive unit 104. A first (front) drive unit 104 may be located at a front of the vehicle. This front drive unit may be mechanically coupled to a front axle of the EV. A second (rear) drive unit may be located at a rear of the vehicle. This rear drive unit may be mechanically coupled to a rear axle of the EV.

In an embodiment, the controller 112 may operate both drive units to perform static heating. Depending on the proximity and/or electrical coupling of the respective drive unit to the ground plane (e.g., a chassis) of the EV, the controller 112 may operate one or both of the drive units to perform static heating with the static heating waveform (omitting the zero vector signals).

For example, in some cases, the front drive unit may be more closely coupled to charging infrastructure of the EV, while the back drive unit is less coupled to the charging infrastructure. Such infrastructure may include low voltage power supplies, communication devices, pilot signals, etc., that the EV 102 uses to communicate with electric vehicle charger 114 during charging. The controller 112 may, in such a case, transmit the static heating waveform pattern to the front drive unit, while transmitting a more traditional waveform pattern (e.g., one containing zero vector signals) to the rear drive unit.

Alternatively, the controller 112 may transmit static heating waveform patterns to both drive units, given that the static heating waveform pattern increases heat generation and reduces common mode noise, which may be generally beneficial for operation of electronics throughout EV 102.

In an embodiment, external electric vehicle charger 114 may comprise a DC fast charger. This may be referred to as level 3 charging. Level 3 chargers may include a DC power source that delivers direct DC power to the vehicle's battery, rather than converting AC from the grid to DC like Level 1 and Level 2 chargers. This eliminates the need for onboard conversion, resulting in faster charging speeds. Level 3 chargers can provide power outputs ranging from 50 kW to over 350 kW, and can charge a vehicle's battery to 80% capacity in a relatively shorter time than level 1 and level 2 charging. The charging rate may vary depending on a battery size and charging capabilities of EV 102, and/or the electric vehicle charger 114 output power.

In an example, EV 102 comprises battery charging infrastructure (not shown) such as a charge port (e.g., a receptacle comprising electric terminals to carry electric power and signals from the electric vehicle charger 114 to the electric vehicle) and a charge controller which may be integral to or separate from controller 112 to communicate with the electric vehicle charger 114, negotiate requisite handshake signaling or pilot signals, if any. The battery charging infrastructure may include a battery charger that includes power switching semiconductors that regulate the voltage and/or current received through the charge port to a voltage and current range that is suitable to charge the battery pack 110, although not required in the case of DC fast charging where the electric vehicle charger 114 may perform the requisite voltage and current regulation to charge the battery pack 110.

Controller 112 may determine that the EV is connected to the external charger by detecting a signal on a charge port of the EV. This may be direct, such as using one or more sensors to detect presence of the plug, or a signal state, or presence of a signal, or indirect, such as by receiving a message from a charge controller that charging is initiated.

In an embodiment, an over the air (OTA) update may be sent to EV 102 to configure controller 112 to perform static heating as described. The OTA update may program controller 112 with optimal temperature range of a battery pack 110, or a temperature threshold, or specify the waveform pattern for each drive unit during static heating, or a combination thereof.

FIG. 2 shows an example of a drive unit 200, in accordance with an embodiment. Drive unit 200 may be an example of a drive unit described with respect to other figures. Drive unit 200 comprises motor 202 and drive circuit 204. Drive circuit 204 may be referred to as a two-level voltage source inverter.

The drive circuit 204 may comprise three pairs of transistors, each pair being electrically coupled to a winding of the electric motor and configured to couple the respective winding to either a positive terminal of the DC bus (DC BUS +) or a negative terminal of the DC bus (DC BUS -). The total voltage across the DC BUS + and DC BUS - terminals may be referred to as Vdc. A midpoint between this voltage may be referred to as Vdc/2, and may be coupled to vehicle ground (g) or the common ground plane. As described, this common ground plane may also be coupled to a low voltage power supply that powers low voltage signaling that communicates with the external charger. When the motor 202 is driven (e.g., for static heating) this may inadvertently introduce noise from the motor to the common ground plane. Common mode voltage (CMV) *umg* may potentially to ride on low voltage signals through common ground path there by compromising the signal quality and integrity.

During zero vectors, switching states of the transistors are [000] and [111], where [000] means that all three of the signals are in 'low' state, and [111] means that all three signals are in 'high' state. The phase voltages of [000] state may be described as: $vAg = vBg = vCg = -Vdc/2$. As such, the common mode voltage *umg* resulting from the [000] state may be $-Vdc/2$. Similarly, the phase voltages of [111] state may be $Vdc/2$, and the resulting *umg* may be $Vdc/2$. The common mode voltage for any other switching state, $vmg = \pm Vdc/6$.

Aspects of the present disclosure reduce and mitigate the magnitude of common mode voltage using a non-zero pulse width modulation (NZVPWM) control for static heating. Unlike traditional space vector PWM (SVPWM), the NZVPWM employs only or exactly three non-zero vectors. Details of these switching schemes are further described with respect to FIG. 3, FIG. 4, and FIG. 5.

FIG. 3 shows an example of vector-based control of a drive unit 300, in accordance with an embodiment. As described, a drive unit 300 may comprise a drive circuit and a three phase motor. The drive circuit may comprise three legs (e.g., leg W, leg V, leg U), each leg comprising a switch (304a, 304b, 304c) formed from a pair of semiconductors. The legs are driven simultaneously by a corresponding signal of the control signals generated by a controller. Each signal switches between high (1) and low (0). Each pair of semiconductors may be driven by a single control signal 302, where one of the semiconductors (e.g., the bottom semiconductor) of the pair always takes the inverse of the signal so that both are never in the closed position at the same time. Given that there are three switches which can be in two different positions each, the total number of possible switch configuration is 2^3=8. The state of the three signals to the three pairs makes up a vector.

V0 is a vector of three signals, each having a low state, expressed as [000].

V1 is a vector where a first signal (e.g., corresponding to leg W) is high, and the remaining signals (corresponding to leg V and leg U) are low, which is expressed as [100]. This vector is illustrated in FIG. 3.

V2 is a vector where a first signal (e.g., corresponding to leg W) is high, the second signal (corresponding to leg V) is high, and the third signal (corresponding to leg U) is low, which is expressed as [110], and so on.

V7 is a vector where all three signals (e.g., corresponding to leg W, V, and U) are high, which is expressed as [111].

All possible vectors for the three signals may be expressed as such:

| Vector 0 | [000] |
|----------|-------|
| Vector 1 | [100] |
| Vector 2 | [110] |
| Vector 3 | [010] |
| Vector 4 | [011] |
| Vector 5 | [001] |
| Vector 6 | [101] |
| Vector 7 | [111] |

This vector table is also shown as a vector diagram 306. Typically (e.g., under driving mode), the voltage reference (Vref) and the desired speed and/or torque of the motor may dictate which vector to command at a given moment in time. For example, depending on the desired rotational speed of the motor, the frequency of the 3 phase AC may be increased or decreased, based on how fast the controller cycles through the vectors. Under SVPWM, all possible states (2^3 = 8) are used over time to command the three-phase motor to turn. SVPWM uses steady state DC-voltage and the six switches (e.g., transistors) to emulate a three-phase sinusoidal waveform where the frequency and amplitude is adjustable (according to switching frequency, period, and pulse duration). As described, however, this may result in undesirable common mode noise which may disrupt battery charging. Further, given that inefficiency is desirable to more quickly heat up the battery to an optimal range, SVPWM may not be a suitable waveform pattern to use the motor for battery heating.

As such, when the controller determines that the battery heating is to be performed, it may generate control signals that are a subset of the 8 vectors, that omits vectors V0 (all low) and V1 (all high) from the waveform pattern. In an embodiment, the pattern may repeat only three vectors V1, V3, and V5. In an embodiment, the waveform pattern may repeat only three vectors V2, V4, and V6. By adjusting the duty cycle of these vectors, a controller aligns the rising and falling edges of three phases to effectively cancel or greatly reduce the common mode noise.

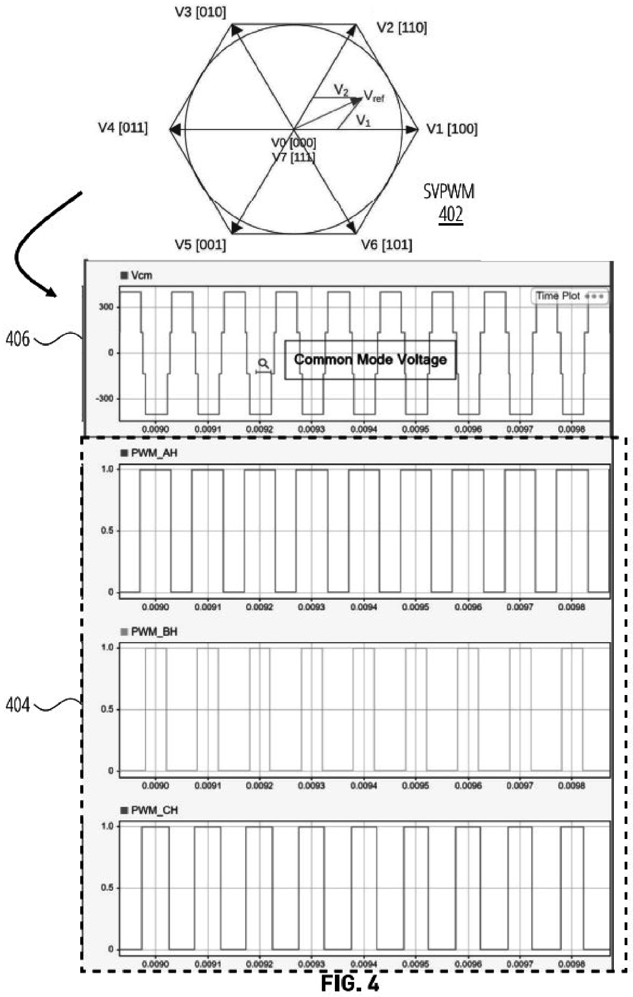

FIG. 4 illustrates an example of common mode voltage that may be induced into a common ground of an EV when switching the motor with SVPWM, in accordance with an embodiment. With static heating enabled, the controller identifies the required stator voltage vector ($\alpha$) (e.g., based on the current position of the rotor or the current voltage across the motor windings) and produces the corresponding 3-phase output voltage using SVPWM. When $\alpha$ vector is in Sector 1 (S1), the controller commands a conventional SVPWM sequence V0→V1→ V2→V7→V2→V1 to the inverter for static heating. The high dv/dt of switching power modules induces common mode voltage, which may potentially couple with electronics (e.g., a proximity pilot (PP)) through a shared ground. As a result, a PP sensing circuit (R_sense) in the EVSE (e.g., a DC charger) detects the high frequency common mode noise and may trigger a charge fault and/or termination of the charging process.

For example, an SVPWM waveform 404 is shown with respect to the common mode voltage 406. SVPWM waveform 404 is generated according to the SVPWM diagram 402. It can be seen that periods of null vectors V0 (all low) and V7 (all high), contribute to the highest CMV (e.g., approximately 400Vdc to negative -400Vdc), at a frequency corresponding to the occurrence of the null vectors. In an embodiment, the controller may use this SVPWM waveform to drive a second drive unit of the EV, such as when this second drive unit is less coupled or farther away from charging infrastructure of the EV. In an embodiment, the controller uses NZVPWM signals to perform static heating on all of its drive units. NZVPWM may also be referred to as non-zero vector control (NZVC).

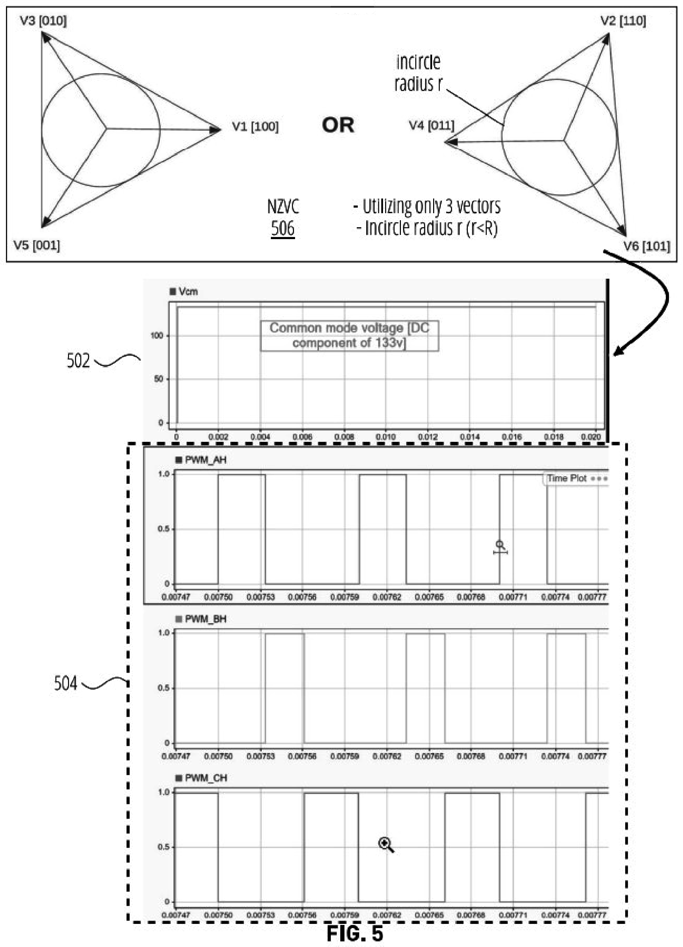

FIG. 5 illustrates an example of common mode voltage that may be induced into a common ground of an EV when switching the motor with non-zero vector control (NZVC), in accordance with an embodiment.

Following the NSVC diagram 506, any reference voltage (*Vref*) within the respective portion of the inscribed circle of the diagram (e.g., S1', S2', or S3') is achieved by a controller by applying vectors V1, V3, or V5.

Static heating waveform 504 is performed based applying the NSVC diagram 506, which in this example, only includes V1, V3, and V5. By omitting null vectors V0 and V7, the CMV magnitude shown in graph 502 is reduced to *Udc*/6 and the CMV frequency is held at 0 Hz.

In an embodiment, Volt-Sec balance is achieved based on:

$$V1*T1+V3*T3+V5*T5 = Vref* \ Ts,$$

and

T1+T3+T5=Ts, where T1, T3, and T5 represent the applied duration of the respective vector, and Ts represents a cycle period of all three vectors.

By solving for the above equation:

$$T1= (1/3+2/3*Vref/Udc*\cos\theta) \ Ts,$$

$$T3= (1/3+2/3*Vref/Udc*\cos(\theta - 120)) \ Ts,$$

and

T5= Ts-T1-T3, which represent the applied duration of V1, V3, and V5.

In the illustrated example, waveform 504 comprises a sequence of V1[100], V2[010], and V5[001] which repeats in pattern and aligned so that no overlap of high states are present in any of the signals. Although shown with V1, V3, V5, the same waveform repetition and application may be performed, but with a sequence of V2, V3, and V6.

By applying the NZVC waveform pattern during static heating, a Total Harmonic Distortion (THD) in the motor is increased, thereby increasing heat generation (compared to SVPWM). Further, by utilizing higher switching frequency (e.g., at or greater than 16kHz), the controller may increase inverter losses and reduce audible noise. A combination of these two phenomenon leads to an increase in power draw (e.g., from 3.8kW to 5.2kW). As result, the drive unit (both the motor and the drive circuit) may heat faster under the NZVC waveform pattern, thereby reducing the battery pack heating time, and reducing unwanted common mode noise.

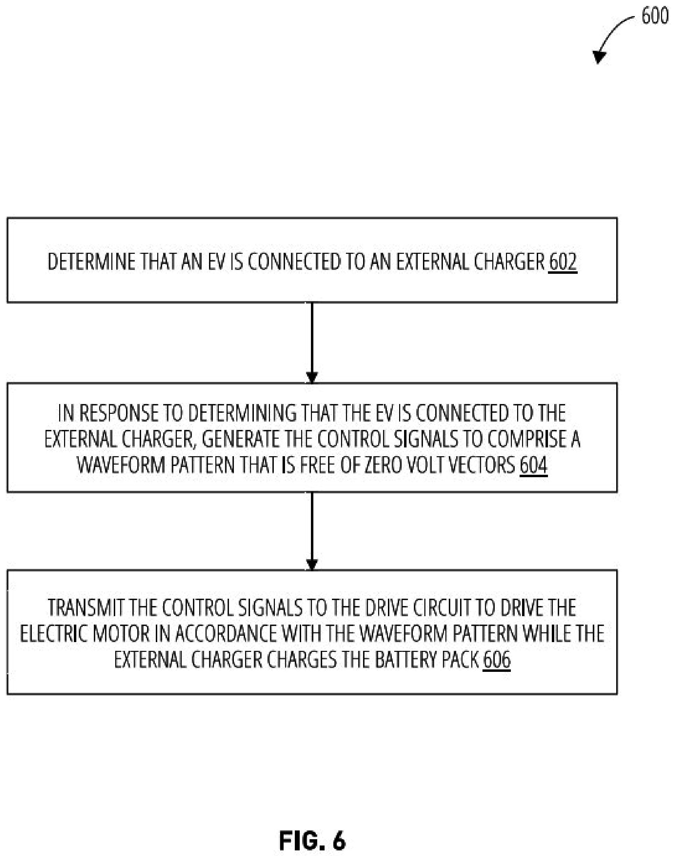

FIG. 6 shows a flow diagram of a method 600 for performing static heating, in accordance with an embodiment. The method 600 may be performed by processing logic that may comprise hardware (circuitry, dedicated logic, etc.), software (such as is run on a general purpose computer system or a dedicated machine), firmware, or a combination.

The method 600 may be performed by a controller of an EV. The EV comprises a battery pack, an electric motor, a drive circuit comprising a plurality of power semi-conductors coupled to a direct current (DC) bus of the EV and coupled to the electric motor, the plurality of power semi-conductors configured to drive the electric motor, and a heat transfer material, arranged to transfer thermal energy from the electric motor to the battery pack, as described in other sections.

At block 602, the method comprises determining that an EV is connected to an external charger. In an embodiment, determining that the EV is connected to the external charger comprises detecting a signal (e.g., a message, pilot signal, etc.) on a charge port of the EV. In an embodiment, determining that the EV is connected to the external charger comprises receiving a message from the external charger (e.g., wirelessly or through the charge port). In other embodiments, the method comprises monitoring the states of one or more sensors (e.g., proximity sensors, voltage sensors, position sensors) to determine whether the EV is connected to an external charger. In an embodiment, in addition or in alternative to determining that the EV is connected to an external charger, the method may comprise determining that a charge is being initiated or is being performed, based on signaling (e.g., a series of handshakes or configuration and acknowledgements) between the EV and the electric vehicle charger.

At block 604, the method comprises in response to determining that the EV is connected to the external charger, generating the control signals to comprise a waveform pattern that is free of zero volt vectors. In an embodiment, the waveform pattern comprises a total of three signals where the states of the signals form a vector, and the waveform pattern comprises only non-zero vectors (e.g., V1, V3, and V5, or V2, V4, and V6) that repeat over a cycle. The waveform pattern is implemented as pulse width modulated (PWM) signals. In an embodiment, the three PWM signals are aligned without overlap of a high position and/or low position (as shown in waveform 504).

At block 606, the method comprises transmitting the control signals to the drive circuit to drive the electric motor in accordance with the waveform pattern while the external charger charges the battery pack. In an embodiment, the method includes monitoring the temperature of the battery pack, and in response to the battery pack temperature exceeding a threshold temperature (e.g., within the optimal temperature range), the control signals are ceased resulting in the ceasing of static heating.

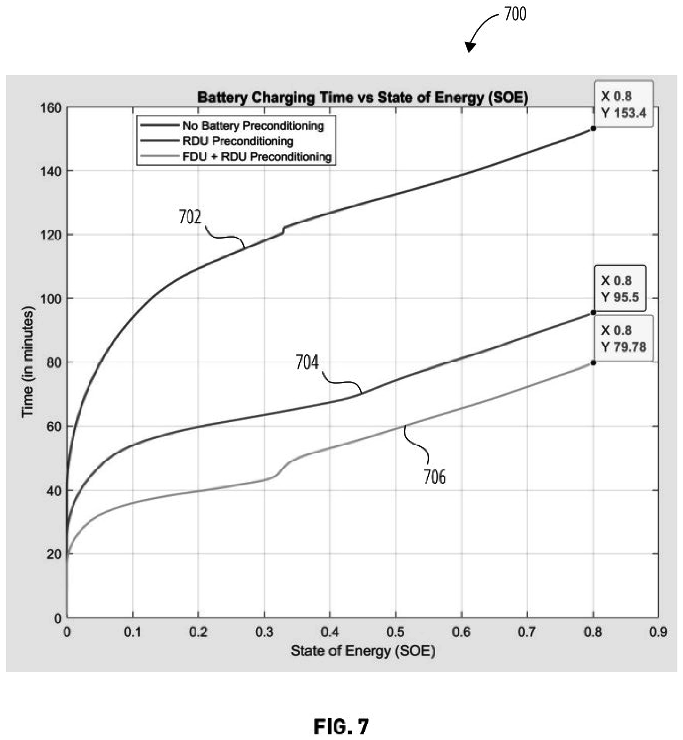

FIG. 7 illustrates a comparison of battery charge times under different conditions, in accordance with an embodiment.

Graph 700 shows simulated charge time (y-axis) vs. state of energy (x-axis) for three cases. State of energy (SOE) refers to a battery pack's remaining stored energy under specific operating conditions. SOE takes into account real-time factors that can affect energy availability, such as temperature and/or load, making it important for reliable performance in different environments. The SOE may be a more dynamic and accurate measure of a battery's ability to provide energy in comparison to State of Charge (SoC). Charge time may refer to the duration during which a battery charges. In this simulation, battery pack starts at temperature: -10°C.

In a first case (702), the battery pack is charged without preconditioning. In a second case (704), the battery pack is preconditioned with a single rear drive unit (RDU). In a third case (706), the battery pack is preconditioned with both the RDU and a front drive unit (FDU).

In the first case, without static heating, the battery pack takes 153 minutes to reach an 80% SOE. In the second case 704, with just the rear drive unit used for static heating, the battery pack takes 95 minutes to reach the 80% SOE. In the third case 706, with utilization of both drive units for static heating, the battery pack takes 79 minutes to reach 80% SOE.

As such, it can be seen using one or both drive units for static heating vastly reduces the charge time of a battery when other conditions are the same. When static heating is performed with a non-zero vector waveform pattern as described, static heating may further increase heat generation while reducing CMV and CM noise, thereby reducing the risk of inadvertently disrupting or delaying the battery charge. Static heating and common mode noise reduction may be performed without the use of dedicated hardware (e.g., filters, chokes, etc.).

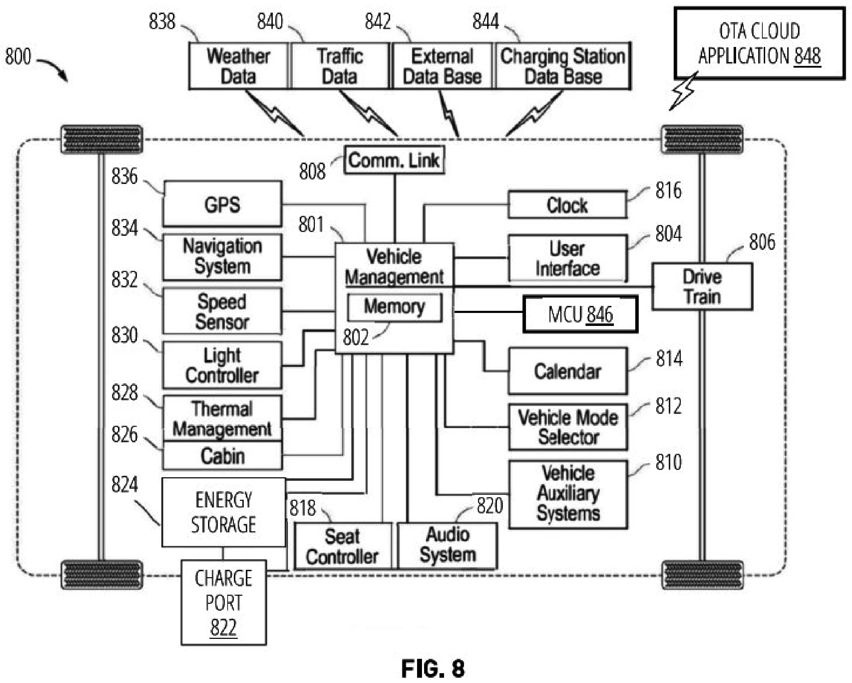

FIG. 8 is a high-level view of some embodiments of a vehicle 800, in accordance with an embodiment. Vehicle 800 can be an electric vehicle (EV), a vehicle utilizing an internal combustion engine (ICE), or a hybrid vehicle, where a hybrid vehicle utilizes multiple sources of propulsion including an electric drive system. Vehicle 800 includes a vehicle on-board system controller 801, also referred to herein as a vehicle management system, which is comprised of one or more processors (e.g., a central processing unit (CPU)). System controller 801 also includes memory 802, with memory 802 being comprised of EPROM, EEPROM, flash memory, RAM, solid state drive, hard disk drive, or any other type of memory or combination of memory types.

In some embodiments, vehicle 800 includes one or more internal networks by which system controller 801 interfaces and communicates with one or more internal subsystems of vehicle 800. System controller 801 can also use the one or more internal networks to transfer communications to and from external locations. In some embodiments, the one or more internal networks can be communicably coupled to one or more networks through a network interface. The network interface can provide for wired and/or wireless communication. When used in a local area networking environment (or a wide area networking environment), the network interface can include an Ethernet interface and the one or more internal networks includes an Ethernet communication network (e.g., an Ethernet Ring, etc.) with an Ethernet Port. Other possible embodiments use other communication devices. For example, in some embodiments vehicle 800 includes a modem for communicating across an internal network and/or with an external network.

In some embodiments, vehicle 800 includes a charge port 822 and one or more batteries (e.g., battery pack, etc.), and a battery charger, as an energy storage system 824 that provides power to portions of vehicle 800. The charge port 822 is used for providing voltage to vehicle 800 for charging the energy storage system 824 (e.g., charging batteries by the use of, for example, an EVSE or other power source in a manner well-known in the art. The charging port 822 can be used to transfer power from a battery of the energy storage system 824 to an external location as part of a vehicle-to-grid power transfer. In some embodiments, charging port 822 includes a communication path for communications between the system controller 801 and the locations external to vehicle 800 such as, for example, the power source providing power (voltage) to vehicle 800 for charging batteries of the energy storage system 824 and a utility distributed energy resource management system (DERMS) or an electric utility company and its facilities.

In some embodiments, energy storage system 824 includes an inverter that generates voltage for transfer to an electric power grid. In some embodiments, the inverter converts DC voltage to AC voltage for transfer to the electric power grid. In some embodiments, the same inverter (or a separate invertor) converts DC voltage to AC voltage for charging a battery of the energy storage system 824 or can provide DC to AC voltage conversion when providing power to an electrical power grid as part of a vehicle-to-grid operation. In the case of DC fast charging, the inverter may be bypassed to charge the battery pack directly with DC voltage from a charger that is connected to 822.

In some embodiments, vehicle 800 includes a user interface 804 is coupled to vehicle management system 801. Interface 804 allows the driver, or a passenger, to interact with the vehicle management system, for example inputting data into the navigation system 834, altering the heating, ventilation and air conditioning (HVAC) system via the thermal management system 826, controlling the vehicle's entertainment system (e.g., radio, CD/DVD player, etc.), adjusting vehicle settings (e.g., seat positions, light controls, etc.), and/or otherwise altering the functionality of vehicle 800. In some embodiments, user interface 804 also includes means for the vehicle management system to provide information to the driver and/or passenger, information such as a navigation map or driving instructions (e.g., via the navigation system 834 and GPS system 836) as well as the operating performance of any of a variety of vehicle systems (e.g., battery pack charge level for an EV, fuel level for an ICE-based or hybrid vehicle, selected gear, current entertainment system settings such as volume level and selected track information, external light settings, current vehicle speed (e.g., via speed sensor 832), current HVAC settings such as cabin temperature and/or fan settings, etc.) via the thermal management system 826. Interface 405 may also be used to warn the driver of a vehicle condition (e.g., low battery charge level or low fuel level) and/or communicate an operating system malfunction (battery system not charging properly, low oil pressure for an ICE-based vehicle, low tire air pressure, etc.). Vehicle 800 can also include other features like an internal clock 816 and a calendar 814.

In some embodiments, user interface 804 includes one or more interfaces including, for example, a front dashboard display (e.g., a cockpit display, etc.), a touch-screen display (e.g., a pilot panel, etc.), as well as a combination of various other user interfaces such as push-button switches, capacitive controls, capacitive switches, slide or toggle switches, gauges, display screens, warning lights, audible warning signals, etc. It should be appreciated that if user interface 804 includes a graphical display, controller 801 may also include a graphical processing unit (GPU), with the GPU being either separate from or contained on the same chip set as the processor.

Vehicle 800 also includes a drive train 806 that can include an internal combustion engine, one or more motors, or a combination of both. The vehicle's drive system can be mechanically coupled to the front axle/wheels, the rear axle/wheels, or both, and may utilize any of a variety of transmission types (e.g., single speed, multispeed) and differential types (e.g., open, locked, limited slip). Drive train 806 may also comprise one or more drive units each comprising a drive circuit and respective motor.

Drivers often alter various vehicle settings, either when they first enter the car or while driving, in order to vary the car to match their physical characteristics, their driving style and/or their environmental preferences. System controller 801 monitors various vehicle functions that the driver may use to enhance the fit of the car to their own physical characteristics, such as seat position (e.g., seat position, seat height, seatback incline, lumbar support, seat cushion angle and seat cushion length) using seat controller 818 and steering wheel position using an auxiliary vehicle system controller 810. In some embodiments, system controller 801 also can monitor a driving mode selector 812 which is used to control performance characteristics of the vehicle (e.g., economy, sport, normal). In some embodiments, system controller 801 can also monitor suspension characteristics using auxiliary vehicle system 810, assuming that the suspension is user adjustable. In some embodiments, system controller 801 also monitors those aspects of the vehicle which are often varied by the user in order to match his or her environmental preferences for the cabin 826, for example setting the thermostat temperature or the recirculation controls of the thermal management system 826 that uses an HVAC controller, and/or setting the radio station/volume level of the audio system using controller 820, and/or setting the lights, either internal lighting or external lighting, using light controller 830. Also, besides using user-input and on-board sensors, system controller 801 can also use data received from an external on-line source that is coupled to the controller via communication link 808 (using, for example, GSM, EDGE, UMTS, CDMA, DECT, Wi-Fi, WiMax, etc.). For example, in some embodiments, system controller 801 can receive weather information using an on-line weather service 838 or an on-line data base 842, traffic data 840 for traffic conditions for the navigation system 834, charging station locations from a charging station database 844, etc. In some embodiments, communication link 808 comprises an Ethernet communication link with an Ethernet Port for external communications.

The system controller 801 can transfer information with the components described above over one or more internal networks, such as those, for example, described above. In some embodiments, the system controller 801 is communicably coupled to one or more of these components via an Ethernet communication network (e.g., an Ethernet Ring, etc.). The Ethernet communication network can be used to transfer other data such as data related to, but not limited to, one or more of a driver-assistance system, telematics, over-the-air updates, etc.

The vehicle may comprise a thermal management system 828 which may include one or more temperature sensors, one or more cooling systems (e.g., liquid lines, coolant, pump, fan, heatsink, heat pipe, cooler, evaporator, refrigeration, etc.).

The vehicle may communicate with OTA cloud application 848 which is responsible for software and firmware updates to each of the updateable components of the vehicle (e.g., GPS 836, navigation system 834, speed sensor 832, light controller 830, thermal management 826, energy storage system 824, seat controller 818, audio system 820, vehicle aux systems 810, vehicle mode selector 812, calendar 814, user interface 804, clock 816, vehicle management 801, communications link 808, or other components not shown.

Motor control unit 846 may comprise one or more processing devices which may comprise a combination of hardware and/or software to generate control signals according to sensed information (e.g., motor position, reference voltage, etc.). The motor control unit 846 may be configured to determine when the vehicle 800 is connected to an external charger through charge port 822. In response, the motor control unit 846 may generate and transmit a static heating waveform pattern (e.g., comprising only non-zero vectors) to the drive train 806, as described in other sections. Motor control unit 846 may correspond to or comprise the controller as described in other sections. The motor control unit 846 may operate cooling systems of thermal management system 828 to transfer thermal energy from the drive unit to the battery pack of energy storage system 824 in an active manner, or the thermal management system 828 may passively transfer the thermal energy, or both.

It is to be understood that the above description is intended to be illustrative, and not restrictive. Many other embodiments will be apparent to those of skill in the art upon reading and understanding the above description. The scope should, therefore, be determined with reference to the appended claims, along with the full scope of equivalents to which such claims are entitled.

The foregoing description, for purpose of explanation, has been described with reference to specific embodiments. However, the illustrative discussions above are not intended to be exhaustive or to limit the described embodiments to the precise forms disclosed. Many modifications and variations are possible in view of the above teachings. The embodiments were chosen and described in order to best explain the principles and practical applications of the various embodiments, to thereby enable others skilled in the art to best utilize the various embodiments with various modifications as may be suited to the particular use contemplated.

## Claims

1. An electric vehicle (EV) comprising:

    a battery pack;
    an electric motor;
    a drive circuit configured to drive the electric motor;
    a heat transfer material, arranged to transfer thermal energy from the electric motor to the battery pack; and
    a controller, configured to perform operations comprising:

       in response to determining that the EV is connected to an external charger, generating control signals comprising a waveform pattern that is free of zero volt vectors; and
       transmitting the control signals to the drive circuit to drive the electric motor in accordance with the waveform pattern while the external charger charges the battery pack.

2. The EV of claim 1, wherein the waveform pattern comprises a total of three non-zero vectors implemented as pulse width modulated (PWM) signals.

3. The EV of claim 2, wherein the PWM signals are aligned without overlap of a high position.

4. The EV of claim 1, wherein the operations further comprise: generating second control signals to comprise a second waveform pattern and transmitting the second control signals to a second drive circuit to drive a second electric motor of the EV, in accordance with the second waveform pattern.

5. The EV of claim 4, wherein the drive circuit and the electric motor are housed in a front portion of the EV and form a front drive unit.

6. The EV of claim 4, wherein the second drive circuit and the second electric motor are housed in a rear portion of the EV and form a rear drive unit.

7. The EV of claim 1, wherein the drive circuit comprises a plurality of power semi-conductors coupled to a direct current (DC) bus of the EV and coupled to the electric motor, wherein the plurality of power semi-conductors comprise three pairs of transistors, each pair being electrically coupled to a winding of the electric motor and configured to couple the respective winding to either a positive terminal of a DC bus or a negative terminal of the DC bus, in accordance with the waveform pattern of the control signals.

8. The EV of claim 1, wherein the external charger comprises a DC fast charger.

9. The EV of claim 1, wherein determining that the EV is connected to the external charger comprises detecting a signal on a charge port of the EV.

10. The EV of claim 1, wherein the heat transfer material comprises a liquid that is thermally coupled to the electric motor and thermally coupled to the battery pack.

11. The EV of claim 1, wherein the EV comprises a common ground plane that is coupled to a low voltage power supply that powers signaling that communicates with the external charger, and is coupled to the electric motor.

12. The EV of claim 1, the waveform pattern comprises an increased switching frequency of 16kHz or greater relative to a second waveform pattern generated when the EV is driving.

13. The EV of claim 1, wherein the operations further comprise: during driving of the EV, generating the control signals with a second waveform pattern comprising an eight vector pattern that includes two zero volt vectors.

14. A method, performed by a controller of an electric vehicle (EV), wherein the EV comprises a battery pack, an electric motor, a drive circuit configured to drive the electric motor, and a heat transfer material, arranged to transfer thermal energy from the electric motor to the battery pack, the method comprising:

in response to determining that the EV is connected to an external charger, generating control signals comprising a waveform pattern that is free of zero volt vectors; and
transmitting the control signals to the drive circuit to drive the electric motor in accordance with the waveform pattern while the external charger charges the battery pack.

15. The method of claim 14, wherein the waveform pattern comprises a total of three non-zero vectors implemented as pulse width modulated (PWM) signals.

16. The method of claim 15, wherein the PWM signals are aligned without overlap of a high position.

17. The method of claim 14, further comprising: generating second control signals to comprise a second waveform pattern and transmitting the second control signals to a second drive circuit to drive a second electric motor of the EV, in accordance with the second waveform pattern.

18. The method of claim 17, wherein the drive circuit and the electric motor are housed in a front portion of the EV and form a front drive unit.

19. The method of claim 17, wherein the second drive circuit and the second electric motor are housed in a rear portion of the EV and form a rear drive unit.

20. The method of claim 14, further comprising: during driving of the EV, generating the control signals with a second waveform pattern comprising an eight vector pattern that includes two zero volt vectors.

CONTROLLER 112

SIGNALS 118

DRIVE UNIT 104

MOTOR 106

DRIVE CIRCUIT 108

DC BUS 120

BATTERY PACK 110

HEAT TRANSFER 116

ELECTRIC VEHICLE CHARGER 114

ELECTRIC VEHICLE 102

**FIG. 1**

EP 4 768 293 A1

**Common-mode voltage ($V_{ng}$) of all eight vectors**

Common-mode voltage $(V_{ng}) = \frac{1}{3}(V_{Ag} + V_{Bg} + V_{Cg})$

| Voltage vector | $V_0$ | $V_1$ | $V_2$ | $V_3$ | $V_4$ | $V_5$ | $V_6$ | $V_7$ |
|---|---|---|---|---|---|---|---|---|
| Common-mode voltage | $\frac{-V_{dc}}{2}$ | $\frac{-V_{dc}}{6}$ | $\frac{V_{dc}}{6}$ | $\frac{-V_{dc}}{6}$ | $\frac{V_{dc}}{6}$ | $\frac{-V_{dc}}{6}$ | $\frac{V_{dc}}{6}$ | $\frac{V_{dc}}{2}$ |

Null vectors $V_0$ [000] and $V_7$ [111] contribute to the highest common mode voltage

**FIG. 2**

**FIG. 3**

FIG. 4

V3 [010]

V2 [110]

incircle
radius r

V1 [100]

OR

V4 [011]

NZVC
506

- Utilizing only 3 vectors
- Incircle radius r (r<R)

V5 [001]

V6 [101]

502

■ Vcm

100

Common mode voltage [DC
component of 133v]

50

0

0   0.002  0.004  0.006  0.008  0.010  0.012  0.014  0.016  0.018  0.020

■ PWM_AH

1.0

Time Plot ● ● ●

0.5

0

0.00747  0.00750  0.00753  0.00756  0.00759  0.00762  0.00765  0.00768  0.00771  0.00774  0.00777

504

■ PWM_BH

1.0

0.5

0

0.00747  0.00750  0.00753  0.00756  0.00759  0.00762  0.00765  0.00768  0.00771  0.00774  0.00777

■ PWM_CH

1.0

0.5

0

0.00747  0.00750  0.00753  0.00756  0.00759  0.00762  0.00765  0.00768  0.00771  0.00774  0.00777

**FIG. 5**

600

DETERMINE THAT AN EV IS CONNECTED TO AN EXTERNAL CHARGER 602

IN RESPONSE TO DETERMINING THAT THE EV IS CONNECTED TO THE EXTERNAL CHARGER, GENERATE THE CONTROL SIGNALS TO COMPRISE A WAVEFORM PATTERN THAT IS FREE OF ZERO VOLT VECTORS 604

TRANSMIT THE CONTROL SIGNALS TO THE DRIVE CIRCUIT TO DRIVE THE ELECTRIC MOTOR IN ACCORDANCE WITH THE WAVEFORM PATTERN WHILE THE EXTERNAL CHARGER CHARGES THE BATTERY PACK 606

**FIG. 6**

FIG. 7

FIG. 8

Europäisches
Patentamt

European
Patent Office

Office européen
des brevets

## EUROPEAN SEARCH REPORT

**Application Number**

EP 25 20 7996

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZHANG ZHE ET AL: "A Hybrid PWM Strategy for Common-mode Voltage Reduction and Voltage Linearity Retainment in Adjustable Speed Drives", 2023 IEEE ENERGY CONVERSION CONGRESS AND EXPOSITION (ECCE) IEEE, 29 October 2023 (2023-10-29), pages 5229-5234, XP034507893, DOI: 10.1109/ECCE53617.2023.10362688 [retrieved on 2023-12-29] * page 5229 - page 5234; figure 1 * ----- | 1-20 | INV. B60K11/02 B60L58/27 B60L15/02 B60L53/24 B60L15/08 H02J7/90 B60L53/62 B60L15/20 B60L50/51 B60L50/60 B60L53/10 B60L53/14 B60L58/26 H01M10/613 H01M10/615 H01M10/625 H02K11/00 |
|  |  |  | TECHNICAL FIELDS SEARCHED (IPC) |
|  |  |  | B60K B60L H01M H02J H02K H02M H03K |

The present search report has been drawn up for all claims

| Place of search | Date of completion of the search | Examiner |
|---|---|---|
| The Hague | 22 May 2026 | Akbudak, Tarik |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

# EP 4 768 293 A1

**EUROPEAN SEARCH REPORT**

Europäisches
Patentamt
European
Patent Office
Office européen
des brevets

Application Number

EP 25 20 7996

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| | | | H02M1/12<br>H03K3/017<br>H03K7/08 |
| | | | **TECHNICAL FIELDS SEARCHED (IPC)** |

The present search report has been drawn up for all claims

| Place of search | Date of completion of the search | Examiner |
|---|---|---|
| The Hague | 22 May 2026 | Akbudak, Tarik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

page 2 of 2